# EUROPEAN PATENT SPECIFICATION

(11) **EP 3 930 075 B1**
(45) Date of publication and mention of the grant of the patent: **13.03.2024**
(21) Application number: 20904212.6
(22) Date of filing: 25.09.2020
(51) Int. Cl.: H01M 10/42, G01R 31/36, G01R 31/367, G01R 31/374, H01M 10/48, G01R 31/3828, G01R 31/392, B60L 58/12, B60L 58/16

(54) **BATTERY PACK OCV-SOC CURVE UPDATE METHOD, BATTERY MANAGEMENT SYSTEM AND VEHICLE**
VERFAHREN ZUR AKTUALISIERUNG DER OCV-SOC-KURVE EINES BATTERIEPACKS, BATTERIEVERWALTUNGSSYSTEM UND FAHRZEUG
PROCÉDÉ DE MISE À JOUR DE COURBE OCV-SOC DE BLOC-BATTERIE, SYSTÈME DE GESTION DE BATTERIE ET VÉHICULE

(30) Priority: 20.12.2019 CN 201911328552
(43) Date of publication of application: 29.12.2021
(73) Proprietor: Contemporary Amperex Technology Co., Limited, Fujian PRC 352100 (CN)
(72) Inventor: TANG, Shenzhi, Ningde, Fujian 352100 (CN); DU, Mingshu, Ningde, Fujian 352100 (CN); LI, Shichao, Ningde, Fujian 352100 (CN); RUAN, Jian, Ningde, Fujian 352100 (CN)
(74) Representative: Ran, Handong
(86) International application number: PCT/CN2020/117861
(87) International publication number: WO 2021/120769

(56) References cited:
- CN-A- 102 468 521
- CN-A- 102 565 710
- CN-A- 103 424 710
- CN-A- 103 969 589
- CN-A- 105 322 222
- CN-A- 105 548 900
- CN-A- 108 896 916
- CN-A- 111 048 857
- DE-A1-102017 200 548
- US-A1- 2012 105 068
- US-A1- 2013 317 771
- US-A1- 2014 214 347
- US-A1- 2017 030 974
- CHEN XIAOKAI ET AL: "A novel approach to reconstruct open circuit voltage for state of charge estimation of lithium ion batteries in electric vehicles", APPLIED ENERGY, ELSEVIER SCIENCE PUBLISHERS, GB, vol. 255, 28 August 2019 (2019-08-28), XP085862623, ISSN: 0306-2619, DOI: 10.1016/J.APENERGY.2019.113758 [retrieved on 2019-08-28]
- YIZHAO GAO ET AL: "Estimation of State-of-Charge and State-of-Health for Lithium-Ion Degraded Battery Considering Side Reactions", JOURNAL OF THE ELECTROCHEMICAL SOCIETY, vol. 165, no. 16, 29 December 2018 (2018-12-29), pages A4018-A4026, XP055717677, ISSN: 0013-4651, DOI: 10.1149/2.0981816jes

## Description

### TECHNICAL FIELD

Embodiments of this application relate to the field of battery technologies, and in particular, to a method for updating an OCV-SOC curve of a battery pack, a battery management system, and a vehicle.

### BACKGROUND

With the development of battery technologies, electric vehicles in place of fuel vehicles have been become an evolution trend of the automotive industry. For a battery of an electric vehicle, an open circuit voltage (OCV) of the battery is one of basic parameters of the battery. In estimating online states of the battery, the OCV of the battery is used as an important calibration parameter. The online states of the battery include state of charge (state of charge, SOC for short), state of health (state of health, SOH for short), net cumulative charge-discharge capacity of the battery, and the like.

In some cases, the applicant finds that the battery is gradually aging with the increase of service time, and the OCV of the battery also changes accordingly. Consequently, errors in estimating the online states of the battery are increasing.

US 2014/214347 relates to detecting open-circuit voltage shifts through optimization fitting of the anode electrode half-cell voltage curve. US2013/317771 relates to changes in the state-of-charge open circuit voltage curve by using regressed parameters in a reduced order physics based model.

### SUMMARY

An objective of the embodiments of this application is to provide a method for updating an OCV-SOC curve of a battery pack, a battery management system, and a vehicle. The OCV-SOC curve of the battery pack is updated based on an aging state of the battery pack, so as to obtain an OCV-SOC curve that meets the aging state of the battery pack and to make it convenient to estimate an online state of the battery pack more accurately.

According to the present invention, a method for updating an OCV-SOC curve of a battery pack is provided as set out in claim 1, a battery management system as set out in claim 8, and a vehicle as set out in claim 9. Other aspects of the invention can be set out in the dependent claims. In the embodiments of this application, the information that represents the aging state of the battery pack is obtained, and then the aging state of the battery pack is quantified with reference to the current OCV-SOC curve of the battery pack and the information that represents the aging state of the battery pack, so as to obtain the current aging characteristic parameter of the battery pack. In this way, the OCV-SOC curve of the battery pack can be updated based on the current aging characteristic parameter of the battery pack and the current OCV-SOC curve of the battery pack. That is, the OCV-SOC curve of the battery pack is updated based on the aging state of the battery pack, so as to obtain the OCV-SOC curve that meets the aging state of the battery pack and to make it convenient to estimate the online state of the battery pack more accurately.

In some embodiments, after updating the OCV-SOC curve of the battery pack based on the current aging characteristic parameter and the current OCV-SOC curve of the battery pack, the method further includes: determining whether the updated OCV-SOC curve of the battery pack satisfies a preset condition; and returning to the step of obtaining the current aging characteristic parameter of the battery pack based on the current OCV-SOC curve of the battery pack and the characterization information if the updated OCV-SOC curve of the battery pack does not satisfy the preset condition. In this embodiment, a step of determining whether the updated OCV-SOC curve of the battery pack satisfies the preset condition is added. Therefore, the OCV-SOC curve of the battery pack can be updated iteratively, and the accuracy of the updated OCV-SOC curve of the battery pack is improved.

In some embodiments, the aging characteristic parameter includes: a scale-down ratio of a positive electrode curve of the battery pack, a scale-down ratio of a negative electrode curve of the battery pack, and a translation ratio of the negative electrode curve of the battery pack.

### BRIEF DESCRIPTION OF DRAWINGS

To describe the technical solutions in the embodiments of this application more clearly, the following outlines the drawings used in the embodiments of this application. Evidently, the drawings outlined below are merely a part of embodiments of this application. A person of ordinary skill in the art may derive other drawings from the outlined drawings without making any creative efforts.
FIG. 1 is a specific flowchart of a method for updating an OCV-SOC curve of a battery pack according to a first embodiment of this application;
FIG. 2 is a specific flowchart of a method for updating an OCV-SOC curve of a battery pack according to a second embodiment of this application;
FIG. 3 is a specific flowchart of a method for updating an OCV-SOC curve of a battery pack according to a third embodiment of this application; and
FIG. 4 is a specific flowchart of a method for updating an OCV-SOC curve of a battery pack according to a fourth embodiment of this application.

### DETAILED DESCRIPTION OF EMBODIMENTS

To make the objectives, technical solutions, and advantages of this application clearer, the following describes the embodiments of this application in detail with reference to accompanying drawings. A person of ordinary skill in the art understands that in each embodiment of this application, many technical details are provided to make readers better understand this application. However, the technical solutions claimed in this application can still be implemented based on variations and modifications of the following embodiments even without the technical details. A first embodiment of this application relates to a method for updating an OCV-SOC curve of a battery pack. The method is applicable to a battery management system of an electric vehicle, and can update the OCV-SOC curve of the battery pack of the electric vehicle.

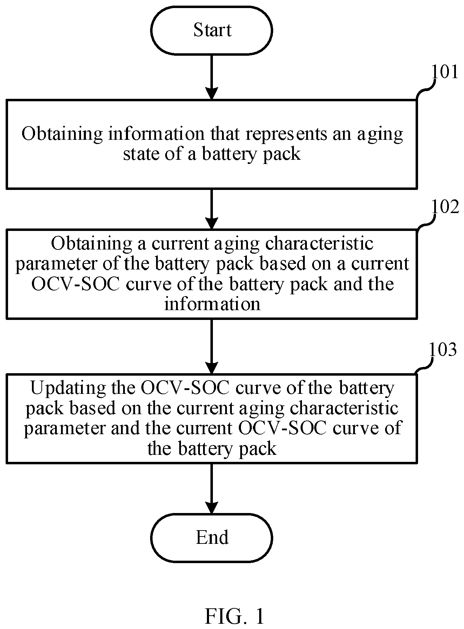

FIG. 1 shows a specific process of a method for updating an OCV-SOC curve of a battery pack according to this embodiment.

Step 101: Obtaining information that represents an aging state of a battery pack.

Specifically, the battery pack of an electric vehicle is aging gradually with increase of the service time of the battery pack. Before the OCV-SOC curve of the battery pack is updated, the information that can represent the aging state of the battery pack is obtained first.

Step 102: Obtaining a current aging characteristic parameter of the battery pack based on a current OCV-SOC curve of the battery pack and the information.

Specifically, the current OCV-SOC curve of the battery pack is obtained. The current OCV-SOC curve may be an initial OCV-SOC curve. Then the aging state of the battery pack is quantified based on the current OCV-SOC curve of the battery pack and the information that represents the aging state of the battery pack, so as to obtain the current aging characteristic parameter of the battery pack.

As an example, the aging characteristic parameter of the battery pack includes the following three parameters:
First, a scale-down ratio Wp of a positive electrode curve caused by a loss of a positive electrode material of the battery pack, that is, a scale-down ratio of a positive electrode OCV-SOC curve of the battery pack, where the scale-down direction is leftward scaling or rightward scaling.
Second, a scale-down ratio Wn of a negative electrode curve caused by a loss of a negative electrode material of the battery pack, that is, a scale-down ratio of a negative electrode OCV-SOC curve of the battery pack, where the scale-down direction is leftward scaling or rightward scaling.
Third, a translation ratio KLLI of the negative electrode curve caused by a lithium loss of the battery pack, that is, a distance by which the negative electrode OCV-SOC curve of the battery pack is translated rightward.

Step 103: Updating the OCV-SOC curve of the battery pack based on the current aging characteristic parameter and the current OCV-SOC curve of the battery pack.

Specifically, a positive electrode OCV-SOC curve and a negative electrode OCV-SOC curve corresponding to the current OCV-SOC curve are obtained; the positive electrode OCV-SOC curve and the negative electrode OCV-SOC curve are updated separately based on the current aging characteristic parameter; and an updated OCV-SOC curve of the battery pack is obtained based on the updated positive electrode OCV-SOC curve and the updated negative electrode OCV-SOC curve.

In this embodiment, the information that represents the aging state of the battery pack is obtained, and then the aging state of the battery pack is quantified based on the current OCV-SOC curve of the battery pack and the information that represents the aging state of the battery pack, so as to obtain the current aging characteristic parameter of the battery pack. In this way, the OCV-SOC curve of the battery pack can be updated based on the current aging characteristic parameter of the battery pack and the current OCV-SOC curve of the battery pack. That is, the OCV-SOC curve of the battery pack is updated based on the aging state of the battery pack, so as to obtain the OCV-SOC curve that meets the aging state of the battery pack and to make it convenient to estimate the online state of the battery pack more accurately. A second embodiment of this application relates to a method for updating an OCV-SOC curve of a battery pack. Compared with the first embodiment, the second embodiment differs primarily in that a specific implementation of updating an OCV-SOC curve of a battery pack is provided.

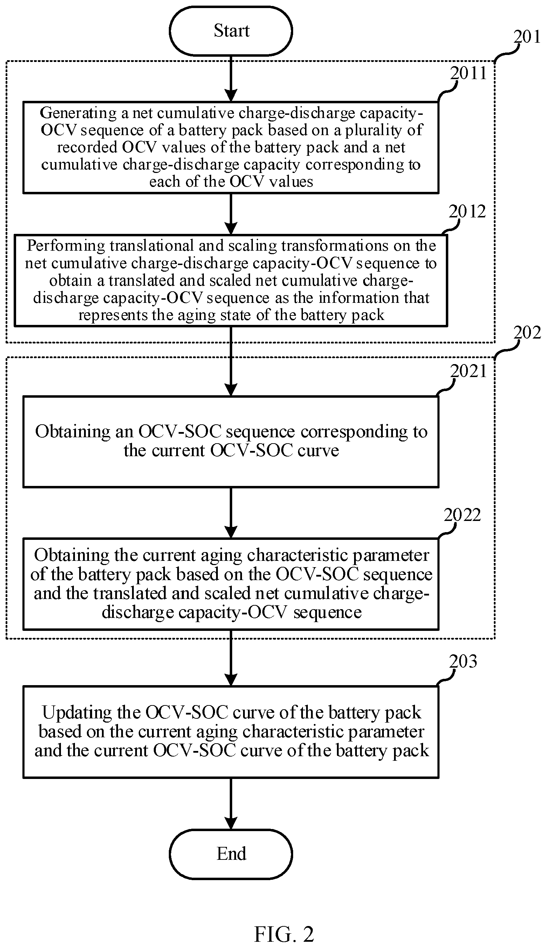

FIG. 2 shows a specific process of a method for updating an OCV-SOC curve of a battery pack according to this embodiment.

Step 201 includes the following substeps.

Substep 2011: Generating a net cumulative charge-discharge capacity-OCV sequence of the battery pack based on a plurality of recorded OCV values of the battery pack and a net cumulative charge-discharge capacity corresponding to each of the OCV values.

Specifically, a plurality of OCV values of the battery pack is recorded. For example, the OCV value is recorded whenever the battery pack has been left standing for a preset period, so that a plurality of OCV values is obtained. At the time of recording each OCV value, the net cumulative charge-discharge capacity of the battery pack is obtained and recorded, so that a plurality of OCV values and a net cumulative charge-discharge capacity corresponding to each OCV value are obtained. A net cumulative charge-discharge capacity-OCV sequence is generated based on the recorded data. The net cumulative charge-discharge capacity is equal to a cumulative charge capacity minus a cumulative discharge capacity. The net cumulative charge-discharge capacity corresponding to the OCV value may be calculated by using an ampere-hour integration method.

Substep 2012: Performing translational and scaling transformations on the net cumulative charge-discharge capacity-OCV sequence to obtain a translated and scaled net cumulative charge-discharge capacity-OCV sequence as the information that represents the aging state of the battery pack.

Specifically, the net cumulative charge-discharge capacity in the net cumulative charge-discharge capacity-OCV sequence is translated and scaled at a preset ratio and by a preset displacement. Q represents a net cumulative charge-discharge capacity, K represents the preset ratio, and b represents the preset displacement. Therefore, the net cumulative charge-discharge capacity-OCV sequence after the translational and scaling transformation is a (KQ+b)-OCV sequence. The (KQ+b)-OCV sequence is the information that represents the aging state of the battery pack.

Step 202 includes the following substeps.

Substep 2021: Obtaining an OCV-SOC sequence corresponding to the current OCV-SOC curve.

Specifically, points on the current OCV-SOC curve are selected to form the OCV-SOC sequence corresponding to the current OCV-SOC curve. The points on the current OCV-SOC curve may be selected at intervals of 1% from 0% to 100% of SOC. It needs to be noted that in this step, the OCV-SOC sequence corresponding to an initial OCV-SOC curve of the battery pack may also be used to perform the following calculations.

Substep 2022: Obtaining the current aging characteristic parameter of the battery pack based on the OCV-SOC sequence and the translated and scaled net cumulative charge-discharge capacity-OCV sequence.

Specifically, the OCV-SOC sequence is corrected based on the current aging characteristic parameter of the battery pack. More specifically, the current aging characteristic parameters include Wp, which is a scale-down ratio of a positive electrode curve; Wn, which is a scale-down ratio of a negative electrode curve; and KLLI, which is a translation ratio of the negative electrode curve. A positive electrode OCV-SOC sequence corresponding to the OCV-SOC sequence of the battery pack is corrected to an OCVp+SOCp×Wp sequence, and a negative electrode OCV-SOC sequence corresponding to the OCV-SOC sequence of the battery pack is corrected to an OCVn+SOCn×Wn+KLLI sequence. The SOCp×Wp in the positive electrode OCV-SOC sequence and the SOCn×Wn+KLLI in the negative electrode OCV-SOC sequence are mapped into an SOC' sequence. The SOC' sequence is usually 0% to 100%. In this way, the positive electrode OCVp'-SOC' sequence and the negative electrode OCVn'-SOC' sequence can be determined. The corrected OCV-SOC sequence of the battery pack is an (OCVp'-OCVn')-SOC' sequence. This sequence includes three unknown numbers: Wp, which is the scale-down ratio of the positive electrode curve; Wn, which is the scale-down ratio of the negative electrode curve; and KLLI, which is the translation ratio of the negative electrode curve. Then, the OCV-SOC sequence that includes the current aging characteristic parameter is compared with the translated and scaled net cumulative charge-discharge capacity-OCV sequence to obtain the current aging characteristic parameter. Specifically, assuming that the (OCVp'-OCVn')-SOC' sequence coincides with the OCV-(KQ+b) sequence, the SOC values corresponding to the same OCV value ought to be equal, and the KQ+b values corresponding to the same OCV value ought to be equal. In this way, a plurality of equations is obtained, and then the values of K, b, Wp, Wn, and KLLI can be determined.

Step 203: Updating the OCV-SOC curve of the battery pack based on the current aging characteristic parameter and the current OCV-SOC curve of the battery pack.

Specifically, based on the values of the current aging characteristic parameters Wp, Wn, and KLLI, the OCV-SOC sequence corresponding to the current OCV-SOC curve is corrected to obtain a corrected OCV-SOC sequence of the battery pack. The specific correction process is similar to substep 2022 and is omitted here. The corrected OCV-SOC sequence is fitted to obtain an OCV-SOC curve, which is an updated OCV-SOC curve of the battery pack.

Compared with the first embodiment, this embodiment provides a specific implementation of updating an OCV-SOC curve of a battery pack.

A third embodiment of this application relates to a method for updating an OCV-SOC curve of a battery pack. Compared with the first embodiment, the third embodiment differs primarily in that another specific implementation of updating an OCV-SOC curve of a battery pack is provided.

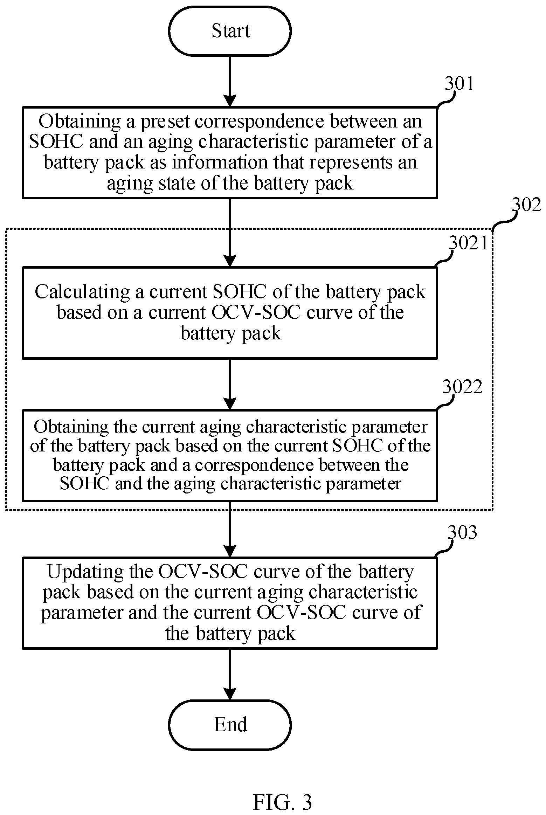

FIG. 3 shows a specific process of a method for updating an OCV-SOC curve of a battery pack according to this embodiment.

Step 301: Obtaining a preset correspondence between an SOHC and an aging characteristic parameter of a battery pack as information that represents an aging state of the battery pack.

Specifically, the SOHC is a ratio of the current capacity of the battery pack to a nominal capacity of the battery pack, and can represent the degree of aging of a battery. OCV-SOV curves of the battery pack with different SOHC values that represent different degrees of aging are obtained beforehand, and a positive electrode OCV-SOC curve and a negative electrode OCV-SOC curve corresponding to each OCV-SOC curve are obtained. The positive electrode OCV-SOC curve and the negative electrode OCV-SOC curve corresponding to each degree of degree are compared with an initial positive electrode OCV-SOC curve and an initial negative electrode OCV-SOC curve corresponding to the initial OCV-SOC curve to obtain a relational expression between each SOHC and the aging characteristic parameter. In this way, a correspondence between SOHC and the aging characteristic parameter is established.

In this embodiment, establishing the relational expression between SOHC and Wp, Wn, and KLLI includes but is not limited to:
determining a relationship between Wp, Wn, and KLLI, for example, determining that Wp is X times Wn;
determining a relationship between SOHC and Wp, Wn, and KLLI severally, for example, before SOHC is greater than 80%, Wn can be ignored; and KLLI is in a linear relationship with SOHC; and
determining a relationship between SOHC and Wp, Wn, and KLLI aggregately, for example, when Wn and KLLI are 0, SOHC = 100% - Wp.

Step 302: includes the following substeps.

Substep 3021: Calculating a current SOHC of the battery pack based on the current OCV-SOC curve of the battery pack.

Specifically, the current SOHC of the battery pack may be calculated based on the current OCV-SOC curve of the battery pack. For example, two SOC values, SOCA and SOCB, are arbitrarily selected first, where SOCA is greater than SOCB. Then OCVA corresponding to SOCA and OCVB corresponding to SOCB are calculated by, for example, using an open circuit voltage method. Based on the current OCV-SOC curve, SOCA' corresponding to OCVA and SOCB' corresponding to OCVB are obtained. A net cumulative charge-discharge capacity corresponding to OCVA, which is denoted by OA, is calculated; and a net cumulative charge-discharge capacity corresponding to OCVB, which is denoted by OB, is calculated. The current SOH of the battery pack is equal to (OA-OB) divided by (SOCA'-SOCB'), and the current SOHC of the battery pack is equal to SOH divided by a nominal capacity of the battery pack.

Substep 3022: Obtaining the current aging characteristic parameter of the battery pack based on the current SOHC of the battery pack and the correspondence between the SOHC and the aging characteristic parameter.

Specifically, the current aging characteristic parameters of the battery pack, Wp, Wn, and KLLI, are calculated based on the current SOHC of the battery pack and the correspondence between the SOHC and the aging characteristic parameter.

Step 303: Updating the OCV-SOC curve of the battery pack based on the current aging characteristic parameter and the current OCV-SOC curve of the battery pack.

Specifically, based on the values of the current aging characteristic parameters Wp, Wn, and KLLI, the OCV-SOC sequence corresponding to the current OCV-SOC curve is corrected to obtain a corrected OCV-SOC sequence of the battery pack. The specific correction process is similar to substep 2022 in the second embodiment and is omitted here. The corrected OCV-SOC sequence is fitted to obtain an OCV-SOC curve, which is an updated OCV-SOC curve of the battery pack.

Compared with the first embodiment, this embodiment provides another specific implementation of updating an OCV-SOC curve of a battery pack.

A fourth embodiment of this application relates to a method for updating an OCV-SOC curve of a battery pack. Compared with the third embodiment, the fourth embodiment makes improvement primarily in that the OCV-SOC curve of the battery pack is updated iteratively.

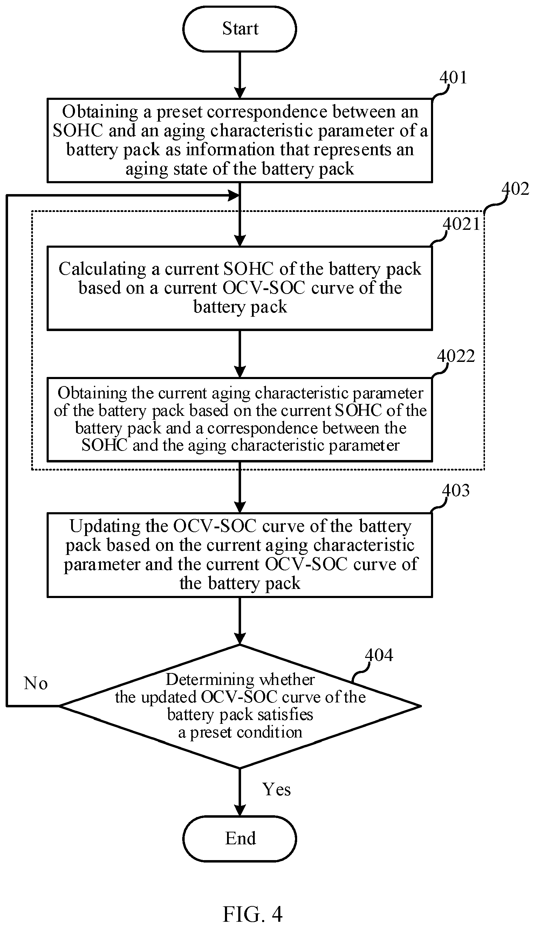

FIG. 4 shows a specific process of a method for updating an OCV-SOC curve of a battery pack according to this embodiment.

In the specific process, steps 401 to 403 are substantially the same as steps 301 to 303, details of which are omitted here. The main difference is that step 404 is added, as described below in detail.

Step 404: Determining whether the updated OCV-SOC curve of the battery pack satisfies a preset condition. If the updated OCV-SOC curve of the battery pack satisfies the preset condition, the process is ended directly; or, if the updated OCV-SOC curve of the battery pack does not satisfy the preset condition, the process goes back to step 402.

Specifically, the preset condition is: a difference between the updated OCV-SOC curve of the battery pack and the non-updated OCV-SOC curve of the battery pack is less than a preset threshold. Determining whether the updated OCV-SOC curve of the battery pack satisfies a preset condition is to determine whether the difference between the updated OCV-SOC curve of the battery pack and the non-updated OCV-SOC curve of the battery pack is less than the preset threshold. If the difference is less than the preset threshold, it indicates that the updated OCV-SOC curve of the battery pack satisfies the preset condition, and the process is ended directly; on the contrary, if the difference is not less than the preset threshold, it indicates that the updated OCV-SOC curve of the battery pack does not satisfy the preset condition, and the process returns to step 402 to recalculate the current aging characteristic parameter of the battery pack based on the updated OCV-SOC curve of the battery pack and the characterization information, and to update the OCV-SOC curve of the battery pack again based on the recalculated current aging characteristic parameter and the updated OCV-SOC curve until the updated OCV-SOC curve of the battery pack satisfies the preset condition.

The difference between the updated OCV-SOC curve of the battery pack and the non-updated OCV-SOC curve of the battery pack is a difference between the OCV-SOC sequence corresponding to the updated OCV-SOC curve of the battery pack and the OCV-SOC sequence corresponding to the non-updated OCV-SOC curve of the battery pack. A variance between two OCVs corresponding to the same SOC in two sequences is calculated, and a sum of all variances is calculated as the difference between the two curves.

In contrast with the third embodiment, this embodiment adds a step of determining whether the updated OCV-SOC curve of the battery pack satisfies the preset condition. Therefore, the OCV-SOC curve of the battery pack can be updated iteratively, and the accuracy of the updated OCV-SOC curve of the battery pack is improved.

A fifth embodiment of this application relates to a battery management system, including: at least one processor; and a memory connected in communication to the at least one processor. The memory stores an instruction executable by the at least one processor. The instruction is executed by the at least one processor to enable the at least one processor to perform the method for updating an OCV-SOC curve of a battery pack according to any one of the first to fourth embodiments.

The memory and the processor are connected by a bus. The bus may include interconnected buses and bridges that are arbitrary in number. The bus connects various circuits of one or more processors and the memory together. The bus can also connect together various other circuits such as peripheral devices, voltage regulators, and power management circuits. This is well known in the art, and therefore, is not further described herein. A bus interface provides an interface between the bus and a transceiver. The transceiver may be one element or a plurality of elements, such as a plurality of receivers and transmitters, and provides a unit configured to communicate with various other devices over a transmission medium. Data processed by the processor is transmitted over a wireless medium through an antenna. Further, the antenna receives the data and transmits the data to the processor. The processor is configured to manage the bus and general processing, and also provides various functions such as timing, peripheral interface, voltage regulation, power management, and other control functions. The memory may be configured to store the data used by the processor in performing an operation.

A sixth embodiment of this application relates to a vehicle, including a battery pack and the battery management system disclosed in the fifth embodiment.

A person of ordinary skill in the art understands that the embodiments described above are detailed embodiments for implementing this application. In practical applications, various modifications may be made in form and detail to the embodiments without departing from the scope of this application as defined by the claims.

## Claims

1. A method for updating an OCV-SOC, i.e. open circuit voltage - state of charge, curve of a battery pack, comprising:
obtaining (101) information that represents an aging state of the battery pack, further comprising obtaining (301) a preset correspondence between an SOHC, i.e. a ratio of the current capacity of the battery pack to a nominal capacity of the battery pack, and
an aging characteristic parameter of the battery pack as the information that represents the aging state of the battery pack;
obtaining (102) a current aging characteristic parameter of the battery pack based on a current OCV-SOC curve of the battery pack and the information;
updating (103) the OCV-SOC curve of the battery pack based on the current aging characteristic parameter and the current OCV-SOC curve of the battery pack;
determining (404) whether the updated OCV-SOC curve of the battery pack satisfies a preset condition, wherein the preset condition is a difference between the updated OCV-SOC curve of the battery pack and the non-updated OCV-SOC curve of the battery pack being less than a preset threshold; and
returning to the step of obtaining (102) the current aging characteristic parameter of the battery pack based on the current OCV-SOC curve of the battery pack and characterization information on condition that the updated OCV-SOC curve of the battery pack does not satisfy the preset condition.

2. The method for updating the OCV-SOC curve of the battery pack according to claim 1, wherein the step of obtaining (101) information that represents the aging state of the battery pack comprises:
generating (2011) a net cumulative charge-discharge capacity-OCV sequence of the battery pack based on a plurality of recorded OCV values of the battery pack and a net cumulative charge-discharge capacity corresponding to each of the OCV values; and
performing (2012) translational and scaling transformations on the net cumulative charge-discharge capacity-OCV sequence to obtain a translated and scaled net cumulative charge-discharge capacity-OCV sequence as the information that represents the aging state of the battery pack.

3. The method for updating the OCV-SOC curve of the battery pack according to claim 2, wherein the step of obtaining (102) current aging characteristic parameter of the battery pack based on the current OCV-SOC curve of the battery pack and characterization information comprises:
obtaining (2021) an OCV-SOC sequence corresponding to the current OCV-SOC curve; and
obtaining (2022) the current aging characteristic parameter of the battery pack based on the OCV-SOC sequence and the translated and scaled net cumulative charge-discharge capacity-OCV sequence.

4. The method for updating the OCV-SOC curve of the battery pack according to claim 3, wherein the step of obtaining (2022) current aging characteristic parameter of the battery pack based on the OCV-SOC sequence and the translated and scaled net cumulative charge-discharge capacity-OCV sequence comprises:
correcting the OCV-SOC sequence based on the current aging characteristic parameter to obtain the OCV-SOC sequence that comprises the current aging characteristic parameter; and
comparing the OCV-SOC sequence that comprises the current aging characteristic parameter with the translated and scaled net cumulative charge-discharge capacity-OCV sequence to obtain the current aging characteristic parameter.

5. The method for updating the OCV-SOC curve of the battery pack according to claim 1, wherein the step of obtaining (102) current aging characteristic parameter of the battery pack based on the current OCV-SOC curve of the battery pack and the information comprises:
calculating (3021) a current SOHC of the battery pack based on the current OCV-SOC curve of the battery pack; and
obtaining (3022) the current aging characteristic parameter of the battery pack based on the current SOHC of the battery pack and the correspondence between the SOHC and the aging characteristic parameter.

6. The method for updating the OCV-SOC curve of the battery pack according to any one of claims 1-5, wherein the step of updating (103) the OCV-SOC curve of the battery pack based on the current aging characteristic parameter and the current OCV-SOC curve of the battery pack comprises:
obtaining a positive electrode OCV-SOC curve and a negative electrode OCV-SOC curve corresponding to the current OCV-SOC curve;
updating the positive electrode OCV-SOC curve and the negative electrode OCV-SOC curve separately based on the current aging characteristic parameter; and
obtaining an updated OCV-SOC curve of the battery pack based on the updated positive electrode OCV-SOC curve and the updated negative electrode OCV-SOC curve.

7. The method for updating the OCV-SOC curve of the battery pack according to any one of claims 1-6, wherein the aging characteristic parameter comprises: a scale-down ratio of a positive electrode curve of the battery pack, a scale-down ratio of a negative electrode curve of the battery pack, and a translation ratio of the negative electrode curve of the battery pack.

8. A battery management system, comprising at least one processor; and
a memory connected in communication to the at least one processor; wherein
the memory stores an instruction executable by the at least one processor, and the instruction is executed by the at least one processor so that the at least one processor is enabled to perform the method for updating an OCV-SOC curve of a battery pack according to any one of claims 1 to 7.

9. A vehicle, comprising a battery pack and a battery management system according to claim 8.

## Patentansprüche

1. Verfahren zum Aktualisieren einer OCV-SOC-, d. h. Leerlaufspannung-Ladezustand-Kurve eines Batteriesatzes, umfassend:
Beschaffen (101) von Informationen, die einen Alterungszustand des Batteriesatzes darstellen, ferner umfassend das Beschaffen (301) einer vorgegebenen Entsprechung zwischen einem SOHC, d. h. einem Verhältnis der aktuellen Kapazität des Batteriesatzes zu einer Nennkapazität des Batteriesatzes, und einem charakteristischen Alterungsparameters des Batteriesatzes als die Informationen, die den Alterungszustand des Batteriesatzes darstellen;
Beschaffen (102) eines aktuellen charakteristischen Alterungsparameters des Batteriesatzes basierend auf einer aktuellen OCV-SOC-Kurve des Batteriesatzes und der Informationen;
Aktualisieren (103) der OCV-SOC-Kurve des Batteriesatzes basierend auf dem aktuellen charakteristischen Alterungsparameter und der aktuellen OCV-SOC-Kurve des Batteriesatzes;
Bestimmen (404), ob die aktualisierte OCV-SOC-Kurve des Batteriesatzes eine vorgegebene Bedingung erfüllt, wobei die vorgegebene Bedingung lautet, dass eine Differenz zwischen der aktualisierten OCV-SOC-Kurve des Batteriesatzes und der nicht aktualisierten OCV-SOC-Kurve des Batteriesatzes geringer als ein vorgegebener Schwellenwert ist; und
Zurückkehren zum dem Schritt des Beschaffens (102) des aktuellen charakteristischen Alterungsparameters des Batteriesatzes basierend auf der aktuellen OCV-SOC-Kurve des Batteriesatzes und Charakterisierungsinformationen unter der Bedingung, dass die aktualisierte OCV-SOC-Kurve des Batteriesatzes die vorgegebene Bedingung nicht erfüllt.

2. Verfahren zum Aktualisieren der OCV-SOC-Kurve des Batteriesatzes nach Anspruch 1, wobei der Schritt des Beschaffens (101) von Informationen, die den Alterungszustand des Batteriesatzes darstellen, Folgendes umfasst:
Erzeugen (2011) einer netto-kumulativen Lade-/Entlade-Kapazität-OCV-Sequenz des Batteriesatzes basierend auf einer Vielzahl von aufgezeichneten OCV-Werten des Batteriesatzes und einer jedem der OCV-Werte entsprechenden netto-kumulativen Lade-Entladekapazität; und
Ausführen (2012) von Verschiebungs- und Skalierungstransformationen an der netto-kumulativen Lade-/Entlade-Kapazität-OCV-Sequenz, um eine verschobene und skalierte netto-kumulative Lade-/Entlade-Kapazität-OCV-Sequenz als die Informationen, die den Alterungszustand des Batteriesatzes darstellen, zu beschaffen.

3. Verfahren zum Aktualisieren der OCV-SOC-Kurve des Batteriesatzes nach Anspruch 2, wobei der Schritt des Beschaffens (102) des aktuellen charakteristischen Alterungsparameters des Batteriesatzes basierend auf der aktuellen OCV-SOC-Kurve des Batteriesatzes und der Charakterisierungsinformationen Folgendes umfasst:
Beschaffen (2021) einer OCV-SOC-Sequenz, die der aktuellen OCV-SOC-Kurve entspricht; und
Beschaffen (2022) des aktuellen charakteristischen Alterungsparameters des Batteriesatzes basierend auf der OCV-SOC-Sequenz und der verschobenen und skalierten netto-kumulativen Lade-/Entladekapazität-OCV-Sequenz.

4. Verfahren zum Aktualisieren der OCV-SOC-Kurve des Batteriesatzes nach Anspruch 3, wobei der Schritt des Beschaffens (2022) des aktuellen charakteristischen Alterungsparameters des Batteriesatzes basierend auf der OCV-SOC-Sequenz und der verschobenen und skalierten netto-kumulativen Lade-/Entlade-Kapazität-OCV-Sequenz Folgendes umfasst:
Korrigieren der OCV-SOC-Sequenz basierend auf dem aktuellen charakteristischen Alterungsparameter, um die OCV-SOC-Sequenz zu beschaffen, die den aktuellen charakteristischen Alterungsparameter umfasst; und
Vergleichen der OCV-SOC-Sequenz, die den aktuellen charakteristischen Alterungsparameter umfasst, mit der verschobenen und skalierten netto-kumulativen Lade-/Entlade-Kapazität-OCV-Sequenz, um den aktuellen charakteristischen Alterungsparameter zu beschaffen.

5. Verfahren zum Aktualisieren der OCV-SOC-Kurve des Batteriesatzes nach Anspruch 1, wobei der Schritt des Beschaffens (102) des aktuellen charakteristischen Alterungsparameters des Batteriesatzes basierend auf der aktuellen OCV-SOC-Kurve des Batteriesatzes und der Informationen Folgendes umfasst:
Berechnen (3021) eines aktuellen SOHC des Batteriesatzes basierend auf der aktuellen OCV-SOC-Kurve des Batteriesatzes; und
Beschaffen (3022) des aktuellen charakteristischen Alterungsparameters des Batteriesatzes basierend auf dem aktuellen SOHC des Batteriesatzes und der Entsprechung zwischen dem SOHC und dem charakteristischen Alterungsparameter.

6. Verfahren zum Aktualisieren der OCV-SOC-Kurve des Batteriesatzes nach einem der Ansprüche 1-5, wobei der Schritt des Aktualisierens (103) der OCV-SOC-Kurve des Batteriesatzes basierend auf dem aktuellen charakteristischen Alterungsparameter und der aktuellen OCV-SOC-Kurve des Batteriesatzes Folgendes umfasst:
Beschaffen einer OCV-SOC-Kurve der positiven Elektrode und einer OCV-SOC-Kurve der negativen Elektrode, die der aktuellen OCV-SOC-Kurve entsprechen;
getrenntes Aktualisieren der OCV-SOC-Kurve der positiven Elektrode und der OCV-SOC-Kurve der negativen Elektrode basierend auf dem aktuellen charakteristischen Alterungsparameter; und
Beschaffen einer aktualisierten OCV-SOC-Kurve des Batteriesatzes basierend auf der aktualisierten OCV-SOC-Kurve der positiven Elektrode und der aktualisierten OCV-SOC-Kurve der negativen Elektrode.

7. Verfahren zum Aktualisieren der OCV-SOC-Kurve des Batteriesatzes nach einem der Ansprüche 1-6, wobei der charakteristische Alterungsparameter Folgendes umfasst: ein Herabsetzungsverhältnis einer Kurve der positiven Elektrode des Batteriesatzes, ein Herabsetzungsverhältnis einer Kurve der negativen Elektrode des Batteriesatzes und ein Verschiebungsverhältnis der Kurve der negativen Elektrode des Batteriesatzes.

8. Batterieverwaltungssystem, umfassend mindestens einen Prozessor; und
einen Speicher, der kommunizierend mit dem mindestens einen Prozessor verbunden ist, wobei
der Speicher eine Anweisung speichert, die von dem mindestens einen Prozessor ausführbar ist, und die Anweisung von dem mindestens einen Prozessor ausgeführt wird, sodass der mindestens eine Prozessor befähigt wird, das Verfahren zum Aktualisieren einer OCV-SOC-Kurve eines Batteriesatzes nach einem der Ansprüche 1 bis 7 auszuführen.

9. Fahrzeug, umfassend einen Batteriesatz und ein Batterieverwaltungssystem nach Anspruch 8.

## Revendications

1. Procédé d'actualisation d'une courbe OCV-SOC, c.-à-d. tension en circuit ouvert-état de charge, d'un bloc-batterie comprenant les étapes consistant à :
obtenir (101) une information qui représente un état de vieillissement du bloc-batterie, comprenant en outre l'étape consistant à obtenir (301) une correspondance prédéfinie entre un SOHC, c.-à-d. un rapport de la capacité actuelle du bloc-batterie à une capacité nominale du bloc-batterie, et un paramètre caractéristique du vieillissement du bloc-batterie en tant qu'information qui représente l'état de vieillissement du bloc-batterie ;
obtenir (102) un paramètre caractéristique du vieillissement actuel du bloc-batterie sur la base d'une courbe OCV-SOC actuelle du bloc-batterie et de l'information ;
actualiser (103) la courbe OCV-SOC du bloc-batterie sur la base du paramètre caractéristique du vieillissement actuel et de la courbe OCV-SOC actuelle du bloc-batterie ;
déterminer (404) si la courbe OCV-SOC actualisée du bloc-batterie satisfait une condition prédéfinie, la condition prédéfinie étant une différence entre la courbe OCV-SOC actualisée du bloc-batterie et la courbe OCV-SOC non actualisée du bloc-batterie qui est inférieure à un seuil prédéfini ; et
revenir à l'étape d'obtention (102) du paramètre caractéristique du vieillissement actuel du bloc-batterie sur la base de la courbe OCV-SOC actuelle du bloc-batterie et de l'information de caractérisation à la condition que la courbe OCV-SOC actualisée du bloc-batterie ne satisfasse pas la condition prédéfinie.

2. Procédé d'actualisation de la courbe OCV-SOC du bloc-batterie selon la revendication 1, dans lequel l'étape d'obtention (101) de l'information qui représente l'état de vieillissement du bloc-batterie comprend les étapes consistant à :
générer (2011) une séquence capacité de charge-décharge cumulée nette-OCV du bloc-batterie sur la base d'une pluralité de valeurs OCV enregistrées du bloc-batterie et d'une capacité de charge-décharge cumulée nette correspondant à chacune des valeurs OCV ; et
effectuer (2012) des transformations par translation et mise à l'échelle de la séquence capacité de charge-décharge cumulée nette-OCV afin d'obtenir une séquence charge-décharge cumulée nette-OCV translatée et mise à l'échelle en tant qu'information qui représente l'état de vieillissement du bloc-batterie.

3. Procédé d'actualisation de la courbe OCV-SOC du bloc-batterie selon la revendication 2, dans lequel l'étape d'obtention (102) du paramètre caractéristique du vieillissement actuel du bloc-batterie sur la base de la courbe OCV-SOC actuelle du bloc-batterie et de l'information de caractérisation comprend les étapes consistant à :
obtenir (2021) une séquence OCV-SOC correspondant à la courbe OCV-SOC actuelle ; et
obtenir (2022) le paramètre caractéristique du vieillissement actuel du bloc-batterie sur la base de la séquence OCV-SOC et de la séquence capacité de charge-décharge cumulée nette-OCV translatée et mise à l'échelle.

4. Procédé d'actualisation de la courbe OCV-SOC du bloc-batterie selon la revendication 3, dans lequel l'étape d'obtention (2022) du paramètre caractéristique du vieillissement actuel du bloc-batterie sur la base de la séquence OCV-SOC et de la séquence capacité de charge-décharge cumulée nette-OCV translatée et mise à l'échelle comprend les étapes consistant à :
corriger la séquence OCV-SOC sur la base du paramètre caractéristique du vieillissement actuel pour obtenir la séquence OCV-SOC qui comprend le paramètre caractéristique du vieillissement actuel ; et
comparer la séquence OCV-SOC qui comprend le paramètre caractéristique du vieillissement actuel avec la séquence capacité de charge-décharge cumulée nette-OCV translatée et mise à l'échelle pour obtenir le paramètre caractéristique du vieillissement actuel.

5. Procédé d'actualisation de la courbe OCV-SOC du bloc-batterie selon la revendication 1, dans lequel l'étape d'obtention (102) du paramètre caractéristique du vieillissement actuel du bloc-batterie sur la base de la courbe OCV-SOC actuelle du bloc-batterie et de l'information comprend les étapes consistant à :
calculer (3021) un SOHC actuel du bloc-batterie sur la base de la courbe OCV-SOC actuelle du bloc-batterie ; et
obtenir (3022) le paramètre caractéristique du vieillissement actuel du bloc-batterie sur la base du SOHC actuel du bloc-batterie et de la correspondance entre le SOHC et le paramètre caractéristique du vieillissement.

6. Procédé d'actualisation de la courbe OCV-SOC du bloc-batterie selon l'une quelconque des revendications 1 à 5, dans lequel l'étape d'actualisation (103) de la courbe OCV-SOC du bloc-batterie sur la base du paramètre caractéristique du vieillissement actuel et de la courbe OCV-SOC actuelle du bloc-batterie comprend les étapes consistant à :
obtenir une courbe OCV-SOC d'électrode positive et une courbe OCV-SOC d'électrode négative correspondant à la courbe OCV-SOC actuelle ;
actualiser la courbe OCV-SOC d'électrode positive et la courbe OCV-SOC d'électrode négative séparément sur la base du paramètre caractéristique du vieillissement actuel ; et
obtenir une courbe OCV-SOC actualisée du bloc-batterie sur la base de la courbe OCV-SOC d'électrode positive actualisée et de la courbe OCV-SOC d'électrode négative actualisée.

7. Procédé d'actualisation de la courbe OCV-SOC du bloc-batterie selon l'une quelconque des revendications 1 à 6, dans lequel le paramètre caractéristique du vieillissement comprend : un rapport de réduction d'une courbe d'électrode positive du bloc-batterie, un rapport de réduction d'une courbe d'électrode négative du bloc-batterie, et un rapport de translation de la courbe d'électrode négative du bloc-batterie.

8. Système de gestion de batterie, comprenant au moins un processeur ; et
une mémoire reliée en communication avec le au moins un processeur ;
la mémoire stockant une instruction pouvant être exécutée par le au moins un processeur, et l'instruction étant exécutée par le au moins un processeur de telle sorte que le au moins un processeur est en mesure d'exécuter le procédé d'actualisation d'une courbe OCV-SOC d'un bloc-batterie selon l'une quelconque des revendications 1 à 7.

9. Véhicule, comprenant un bloc-batterie et un système de gestion de batterie selon la revendication 8.
